(19) Europäisches Patentamt
European Patent Office
Office européen des brevets

(11) **EP 4 391 388 A1**

(12) **EUROPEAN PATENT APPLICATION**
published in accordance with Art. 153(4) EPC

(43) Date of publication:
**26.06.2024 Bulletin 2024/26**

(21) Application number: **22879792.4**

(22) Date of filing: **21.03.2022**

(51) International Patent Classification (IPC):
**H03M 1/10** (2006.01)

(52) Cooperative Patent Classification (CPC):
**H03M 1/10; H03M 1/12**

(86) International application number:
**PCT/CN2022/081949**

(87) International publication number:
**WO 2023/060841 (20.04.2023 Gazette 2023/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.10.2021 CN 202111189751**

(71) Applicant: **Sanechips Technology Co., Ltd.
Shenzhen, Guangdong 518055 (CN)**

(72) Inventor: **CHEN, Xiao
Shenzhen, Guangdong 518057 (CN)**

(74) Representative: **Canzler & Bergmeier
Patentanwälte
Partnerschaft mbB
Despag-Straße 6
85055 Ingolstadt (DE)**

(54) **ANALOG-TO-DIGITAL CONVERTER AND INTER-STAGE GAIN CALIBRATION METHOD**

(57)     Provided in the present application are an analog-to-digital converter and an inter-stage gain calibration method. The analog-to-digital converter comprises a sampling and holding circuit, which is configured to periodically sample and hold an analog input signal; a first-stage analog-to-digital sub-converter, which is configured to convert the analog input signal into a first digital signal, convert the first digital signal into a first voltage signal, and process a difference between the analog input signal and the first voltage signal, so as to obtain a second voltage signal; a first processing circuit, which is configured to perform clock synchronization and period delay on the first digital signal, so as to obtain a second digital signal; an inter-stage amplifier, which is realized by using an open-loop structure, and is configured to amplify the second voltage signal to obtain a third voltage signal; a second-stage analog-to-digital sub-converter, which is configured to convert the third voltage signal into a third digital signal; a second processing circuit, which is configured to perform clock synchronization on the third digital signal, so as to obtain a fourth digital signal; and an adder, which is configured to combine and add the second digital signal as a high-bit codeword and the fourth digital signal as a low-bit codeword, so as to obtain a digital output signal.

FIG. 1

EP 4 391 388 A1

**Description**

CROSS-REFERENCE TO RELATED APPLICATIONS

The present application claims the priority of Chinese Patent Application No. 202111189751.9, filed on October 12, 2021, the contents of which are incorporated herein in their entirety by reference.

TECHNICAL FIELD

The present application relates to the field of analog-to-digital conversion technologies, and in particular, to an analog-to-digital converter and an inter-stage gain calibration method.

BACKGROUND

As integrated circuit fabrication processes enter a nanometer scale, analog-to-digital converters operate at increasingly faster speeds. An inter-stage amplifier in an analog-to-digital converter with a pipeline structure or in an analog-to-digital converter with a pipeline successive approximation register structure is generally implemented by adopting a switched-capacitor closed-loop amplification structure, and cooperates with a corresponding calibration circuit to calibrate inter-stage gains, but at a relatively high operation speed, a design expectation on a bandwidth of an operational amplifier in the closed-loop amplification structure is very high, and the power consumption is very high, so that the closed-loop amplification structure is difficult to be implemented at the relatively high operation speed.

SUMMARY

In a first aspect, an embodiment of the present application provides an analog-to-digital converter, including: a sample-and-hold circuit configured to periodically sample and hold an analog input signal; a first-stage analog-to-digital sub-converter configured to perform a first analog-to-digital conversion on a held analog input signal to obtain a first digital signal, perform a digital-to-analog conversion on the first digital signal to obtain a first voltage signal, and compare the held analog input signal and the first voltage signal to obtain a second voltage signal; a first processing circuit configured to perform a clock synchronization and a cycle delay on the first digital signal to obtain a second digital signal; an inter-stage amplifier implemented in an open-loop structure and configured to perform amplification processing on the second voltage signal to obtain a third voltage signal; a second-stage analog-to-digital sub-converter configured to perform a second analog-to-digital conversion on the third voltage signal to obtain a third digital signal; a second processing circuit configured to perform a clock synchronization on the third digital signal to obtain a fourth digital signal; and an adder configured to combine and add the second digital signal serving as a high-order codeword and the fourth digital signal serving as a low-order codeword to obtain a digital output signal.

In a second aspect, an embodiment of the present application provides an inter-stage gain calibration method, applied to a front-end calibration phase of the analog-to-digital converter described above, including: adjusting, by a gain configuration circuit, an inter-stage gain of an inter-stage amplifier according to a current gain control code; the current gain control code is an integer between 0 to $2^q-1$, q is an integer greater than or equal to 2; determining, by an output detection circuit, to continue inter-stage gain calibration according to a digital output signal corresponding to the current gain control code and a digital output signal corresponding to a previous gain control code, adding 1 to the current gain control code to obtain a next gain control code, and adjusting, by the gain configuration circuit, the inter-stage gain of the inter-stage amplifier according to the next gain control code; and determining, by the output detection circuit, to stop the inter-stage gain calibration according to the digital output signal corresponding to the current gain control code and the digital output signal corresponding to the previous gain control code, determining a desired gain control code and outputting the desired gain control code to the gain configuration circuit, adjusting, by the gain configuration circuit, the inter-stage gain of the inter-stage amplifier according to the desired gain control code; the desired gain control code is one of the current gain control code or the previous gain control code.

BRIEF DESCRIPTION OF DRAWINGS

Fig. 1 is a circuit schematic diagram of an analog-to-digital converter according to an embodiment of the present application;
Fig. 2 is a circuit schematic diagram of an analog-to-digital converter provided with a differential signal serving as an analog input signal according to an embodiment of the present application;

Fig. 3 is a circuit schematic diagram of an inter-stage amplifier according to an embodiment of the present application;

Fig. 4 is a circuit schematic diagram of an inter-stage amplifier provided with a differential signal serving as an analog input signal according to an embodiment of the present application;

Fig. 5 is a schematic diagram of combining and adding a second digital signal serving as a high-order codeword and a fourth digital signal serving as a low-order codeword to obtain a digital output signal according to an embodiment of the present application;

Fig. 6 is a flowchart of an inter-stage gain calibration method according to an embodiment of the present application.

DETAIL DESCRIPTION OF EMBODIMENTS

In order to make those skilled in the art better understand the technical solutions of the present application, an analog-to-digital converter and an inter-stage gain calibration method are described in detail below with reference to the accompanying drawings.

Exemplary embodiments are described in detail below with reference to the accompanying drawings, but the present application may be embodied in different forms, and should not be construed as limited to the embodiments set forth herein. The embodiments are illustrated to make the present application more thorough and complete, and for those skilled in the art more fully understanding the scope of the present application.

The embodiments of the present application and the technical features in the embodiments may be combined with each other if no conflict is incurred.

As used herein, a term "and/or" includes any and all combinations of at least one of listed items.

The terms used in the present application are for a purpose of describing particular embodiments only, and are not intended to limit the present application. As used in the present application, singular forms "a" and "the" are intended to include plural forms as well, i.e., to represent at least one, unless the context clearly defines otherwise. It should further be understood that terms "includes/comprises" and/or "made of/consisted of" in the present application are used to specify a presence of at least one of recited features, integers, steps, operations, elements or components, but do not preclude a presence or an addition of at least one of other features, integers, steps, operations, elements, components or groups thereof.

Unless otherwise defined, meanings of all terms (including technical terms and scientific terms) used herein are the same as meanings commonly understood by one of ordinary skill in the art. It should further be understood that terms, such as those defined in common dictionaries, should be construed as having a meaning that is consistent with that in background of the existing art and the present application, and should not be construed as having an idealized or over-formal meaning, unless expressly defined in the present application.

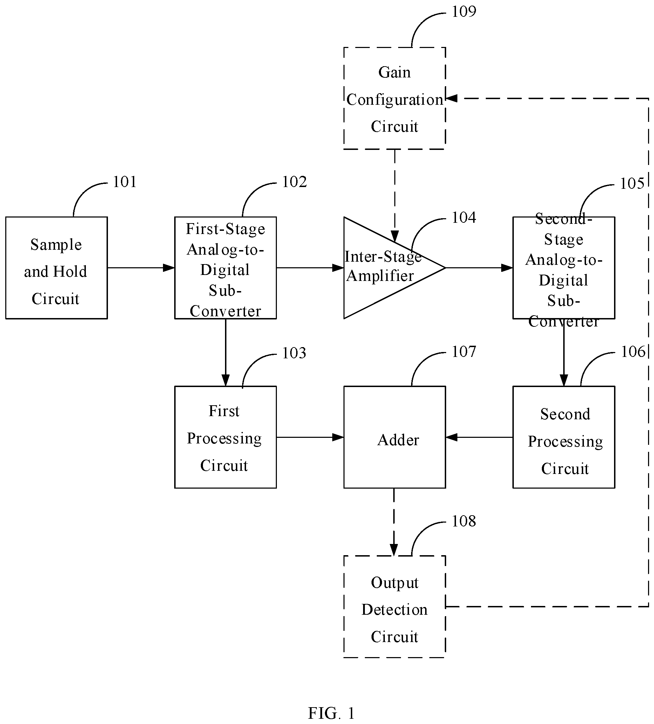

Fig. 1 is a circuit schematic diagram of an analog-to-digital converter according to an embodiment of the present application.

In a first aspect, referring to Fig. 1, an embodiment of the present application provides an analog-to-digital converter, including: a sample-and-hold circuit 101 configured to periodically sample and hold an analog input signal; a first-stage analog-to-digital sub-converter 102 configured to perform a first analog-to-digital conversion on a held analog input signal to obtain a first digital signal, perform a digital-to-analog conversion on the first digital signal to obtain a first voltage signal, and compare the held analog input signal and the first voltage signal to obtain a second voltage signal; a first processing circuit 103 configured to perform a clock synchronization and a cycle delay on the first digital signal to obtain a second digital signal; an inter-stage amplifier 104 implemented in an open-loop structure and configured to perform amplification processing on the second voltage signal to obtain a third voltage signal; a second-stage analog-to-digital sub-converter 105 configured to perform a second analog-to-digital conversion on the third voltage signal to obtain a third digital signal; a second processing circuit 106 configured to perform a clock synchronization on the third digital signal to obtain a fourth digital signal; and an adder 107 configured to combine and add the second digital signal serving as a high-order codeword and the fourth digital signal serving as a low-order codeword to obtain a digital output signal.

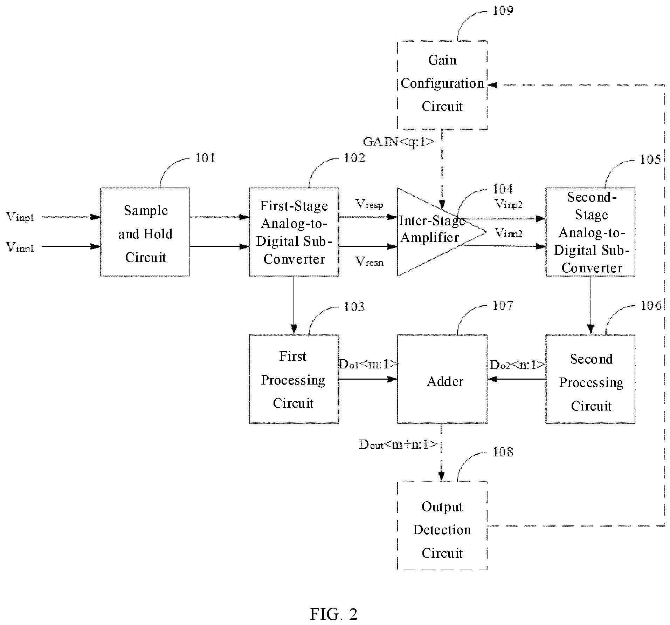

In the embodiment of the present application, the analog input signal, the first voltage signal, the second voltage signal, and the third voltage signal each may be a differential signal, or a non-differential signal. For example, as shown in Fig. 2, the analog input signal includes differential signals $V_{inp1}$ and Vinni, the first voltage signal includes differential signals $V_{DACp}$ and $V_{DACn}$ ($V_{DACp}$ and $V_{DACn}$ belong to internal signals of the first-stage analog-to-digital sub-converter 102 and are not shown in Fig. 2), the second voltage signal includes differential signals $V_{resp}$ and $V_{resn}$, the third voltage signal includes differential signals $V_{inp2}$ and $V_{inn2}$, $V_{inp1}$ and $V_{DACp}$ are subtracted to obtain $V_{resp}$, $V_{inn1}$ and $V_{DACn}$ are compared to obtain $V_{resn}$; the inter-stage amplifier 104 amplifies a residual voltage signal (the residual voltage signal is a difference between $V_{resp}$ and $V_{resn}$) to obtain a difference between the differential signals $V_{inp2}$ and $V_{inn2}$.

In some implementations, the analog input signal being sampled and held includes that after sampling the analog input signal, the sample-and-hold circuit 101 holds a signal input into the first-stage analog-to-digital sub-converter 102 as the sampled analog input signal unchanged.

In some implementations, the first-stage analog-to-digital sub-converter 102 being configured to perform the digital-to-analog conversion on the first digital signal to obtain the first voltage signal includes that, the first-stage analog-to-digital sub-converter 102 controls a digital-to-analog converter inside the first-stage analog-to-digital sub-converter 102 to perform the digital-to-analog conversion on the first digital signal according to the first digital signal, so as to obtain the first voltage signal.

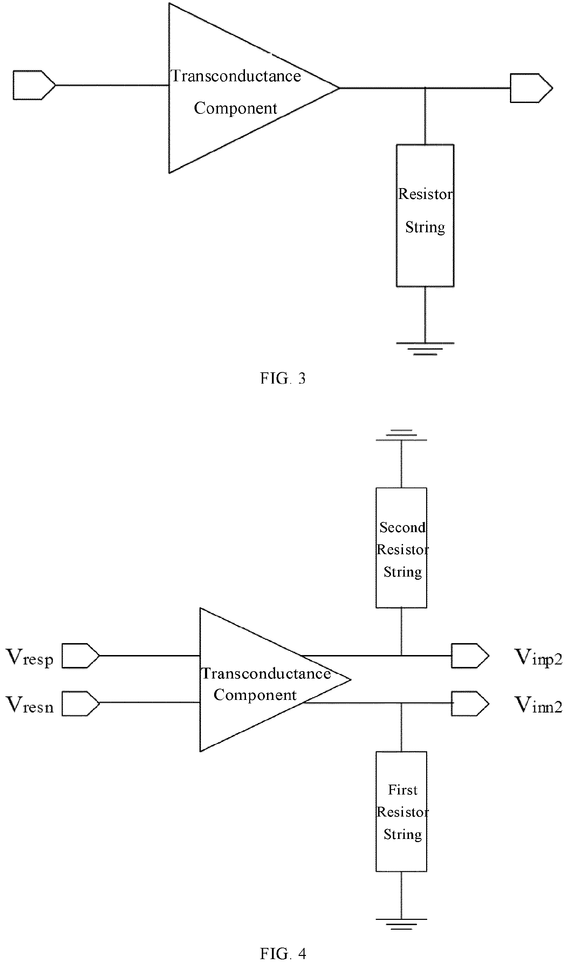

In some implementations, as shown in Fig. 3, the inter-stage amplifier 104 includes a transconductance component and a resistor string; an input end of the transconductance component is connected to an output end of the first-stage analog-digital sub-converter 102, which is configured to output the second voltage signal, an output end of the transconductance component is connected to an input end of the second-stage analog-digital sub-converter 105, and is connected to ground or a power supply or a common-mode direct current level through the resistor string.

In some implementations, the transconductance component refers to a circuit having a capability of converting an input voltage signal into a current signal, and may include a transistor and other passive devices. For example, the transconductance component includes a first Metal Oxide Semiconductor (MOS) transistor, a second MOS transistor, and a current source; gate electrodes of the first MOS transistor and the second MOS transistor are used as input ends of the transconductance component, drain electrodes of the first MOS transistor and the second MOS transistor are used as the output ends of the transconductance component, and source electrodes of the first MOS transistor and the second MOS transistor are connected and grounded through the current source; for another example, the transconductance component includes a first triode, a second triode, and a current source; base electrodes of the first triode and the second triode are used as the input ends of the transconductance component, collector electrodes of the first triode and the second triode are used as the output ends of the transconductance component, and emitter electrodes of the first triode and the second triode are connected and grounded through the current source.

In some implementations, the resistor string may be formed by connecting two or more resistors in series, may be formed by connecting two or more resistors in parallel, or may be formed by connecting two or more resistors in series-parallel, i.e., in series and in parallel. The resistors in the resistor string may be adjustable resistors, or resistors connected in series with a switch, and any manner in which a resistance value of the resistor string is acceptable.

In some implementations, in a case where the analog input signal, the first voltage signal, the second voltage signal, and the third voltage signal are differential signals, the inter-stage amplifier 104 includes two input ends, two output ends, two resistor strings, and a transconductance component, and as shown in Fig. 4, each output end of the inter-stage amplifier 104 is grounded through one resistor string, specifically, a first output end is grounded through a first resistor string, and a second output end is grounded through a second resistor string.

The inter-stage amplifier 104 in the embodiment of the present application may be implemented in the open-loop structure, and adjusts the inter-stage gain by the transconductance component and the resistor string, therefore a load of a pre-circuit of the inter-stage amplifier 104 is only an input capacitance of the inter-stage amplifier 104, which is more beneficial to a low power consumption design and is easier to be applied to an analog-to-digital converter with a relatively high operation speed.

In the embodiment of the present application, purposes of performing the clock synchronization and the cycle delay on the first digital signal and performing the clock synchronization on the third digital signal is to ensure that the second digital signal and the fourth digital signal can be output at one clock tick, so that the adder 107 can combine and add the second digital signal serving as the high-order codeword and the fourth digital signal serving as the low-order codeword to obtain the digital output signal.

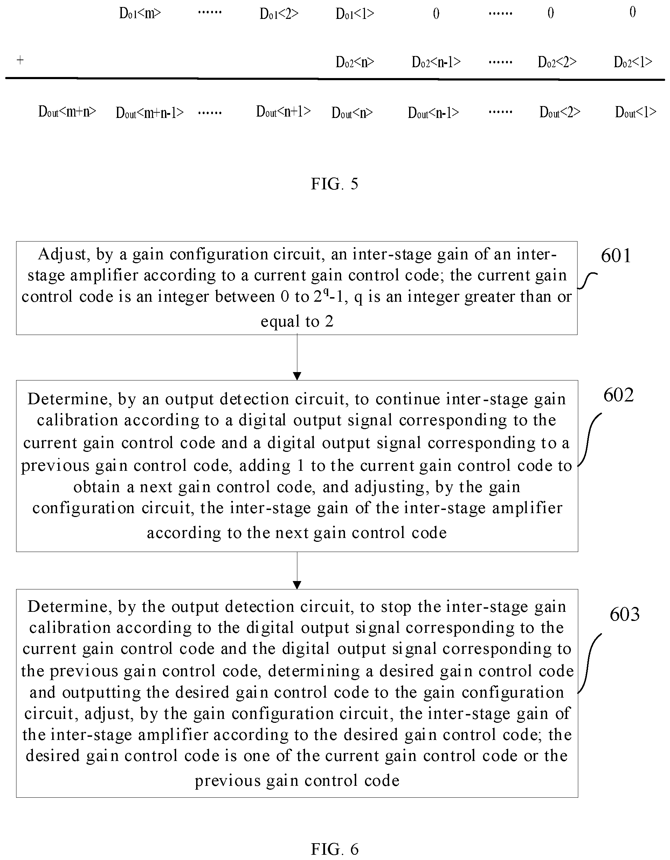

In some implementations, the adder 107 is specifically configured to: supplement (n-1) zeros in a latter part of the second digital signal, and add the second digital signal with the supplemented zeros and the fourth digital signal to obtain the digital output signal; n is a total number of bits of the fourth digital signal. For example, as shown in Fig.5, assuming that the second digital signal is $D_{o1}<m: 1>$, m is an integer greater than or equal to 2, m is a total number of bits of the second digital signal, and the fourth digital signal is $D_{o2}<n: 1>$, n is an integer greater than or equal to 3, considering that an addition of a last bit of the second digital signal and a first bit of the fourth digital signal may generate a carry bit, the digital output signal $D_{out}<m+n: 1>$ finally obtained includes (m+n) bits instead of (m+n-1) bits, and there is a redundant bit.

In some implementations, the analog-to-digital converter further includes: an output detection circuit 108 configured to output a gain control code GAIN<q: 1> to a gain configuration circuit 109 according to the digital output signal; and the gain configuration circuit 109 configured to adjust an inter-stage gain of the inter-stage amplifier 104 according to the gain control code GAIN<q: 1>.

In some implementations, the gain configuration circuit 109 adjusts an equivalent transconductance of the transconductance component and a resistance value of the resistor string, according to the gain control code GAIN<q: 1>, to adjust the inter-stage gain, specifically, $G=g_m R_{out}$, $g_m$ is the equivalent transconductance of the transconductance component, $R_{out}$ is the resistance value of the resistor string, and G is the inter-stage gain.

In the embodiment of the present application, the inter-stage gain G may be configured to correspond to the gain control code, for example, the inter-stage gain G is set to become greater as the gain control code increases.

The analog-to-digital converter in the embodiment of the present application may be an analog-to-digital converter with a high-speed pipeline structure, or may be an analog-to-digital converter with a pipeline successive approximation register structure.

In some implementations, the output detection circuit 108 and the gain configuration circuit 109 may implement a front-end calibration on the inter-stage gain of the analog-to-digital converter by using the inter-stage gain calibration method described above in the embodiment of the present application.

The analog-to-digital converter provided in the embodiment of the present application adopts the open-loop structure to simply implement the inter-stage amplifier, and compared with the switched-capacitor closed-loop amplification structure, the inter-stage amplifier of the analog-to-digital converter in the embodiment of the present application is more simple in structure, has a lower complexity in circuit and a lower power consumption, and a higher operation speed can be achieved under a lower power consumption.

Fig. 6 is a flowchart of an inter-stage gain calibration method according to an embodiment of the present application.

In a second aspect, referring to Fig. 6, an embodiment of the present application provides an inter-stage gain calibration method, applied to a front-end calibration phase of the analog-to-digital converter described above, the front-end calibration phase refers to a gain calibration phase performed before the analog-to-digital converter normally operates, and the inter-stage gain calibration method includes following operations 601 to 603.

At operation 601, adjusting, by a gain configuration circuit, an inter-stage gain of an inter-stage amplifier according to a current gain control code; the current gain control code is an integer between 0 to $2^q-1$, q is an integer greater than or equal to 2.

In some implementations, the gain configuration circuit adjusts an equivalent transconductance of the transconductance component and a resistance value of the resistor string, according to the gain control code GAIN<q: 1>, to adjust the inter-stage gain, specifically, $G=g_mR_{out}$, $g_m$ is the equivalent transconductance of the transconductance component, $R_{out}$ is the resistance value of the resistor string, and G is the inter-stage gain.

In the embodiment of the present application, the inter-stage gain G may be configured to correspond to the gain control code, for example, the inter-stage gain G is set to become greater as the gain control code increases, and specifically, the inter-stage gain G may be set to be increased by a fixed value $\Delta G$ every time the gain control code is increased by 1.

In the embodiment of the present application, in order to obtain a better calibration effect, a value of the q may be set to be greater, so that a distribution of inter-stage gains is relatively dense. In the embodiment of the present application, it is desired to ensure that a desired value of the inter-stage gain is set within a gain range corresponding to gain control codes 0 to $2^q-1$, and the desired value of the inter-stage gain corresponds to the gain control code at an intermediate position as much as possible, and if the desired value of the inter-stage gain is set outside the gain range corresponding to the gain control codes 0 to $2^q-1$, the calibration cannot be performed.

Assuming that a reference voltage of the first-stage analog-to-digital sub-converter is $V_{ref1}$, a reference voltage of the second-stage analog-to-digital sub-converter is $V_{ref2}$, ideally, a ratio between a voltage measure range of the first-stage analog-to-digital sub-converter and a voltage measure range of the second-stage analog-to-digital sub-converter should be $V_{ref1}/V_{ref2}$, then it can be deduced that the desired value of the inter-stage gain of the inter-stage amplifier is $G_0=2^{m-1}(V_{ref2}/V_{ref1})$; $G_0$ is the desired value of the inter-stage gain.

At operation 602, determining, by an output detection circuit, to continue inter-stage gain calibration according to a digital output signal corresponding to the current gain control code and a digital output signal corresponding to a previous gain control code, adding 1 to the current gain control code to obtain a next gain control code, and adjusting, by the gain configuration circuit, the inter-stage gain of the inter-stage amplifier according to the next gain control code.

In some implementations, the digital output signal corresponding to the current gain control code refers to a digital output signal output by the analog-to-digital converter after the gain configuration circuit adjusts the inter-stage gain of the inter-stage amplifier according to the current gain control code; and the digital output signal corresponding to the previous gain control code refers to a digital output signal output by the analog-to-digital converter after the gain configuration circuit adjusts the inter-stage gain of the inter-stage amplifier according to the previous gain control code.

In some implementations, the determining, by an output detection circuit, to continue inter-stage gain calibration according to a digital output signal corresponding to the current gain control code and a digital output signal corresponding to a previous gain control code includes: comparing, by the output detection circuit, the digital output signal corresponding to the current gain control code with the digital output signal corresponding to the previous gain control code; and determining, by the output detection circuit, that no jump is occurred between the digital output signal corresponding to the current gain control code and the digital output signal corresponding to the previous gain control code; or, a jump between the digital output signal corresponding to the current gain control code and the digital output signal corresponding to the previous gain control code is not from a fifth digital signal to a sixth digital signal; an $(m+n-1)^{th}$ bit and an $(n-1)^{th}$ bit in the fifth digital signal are 1, and the rest bits are 0; an $(m+n-1)^{th}$ bit, and an $(n-2)^{th}$ bit to a first bit in the sixth digital signal are 1, and the rest bits are 0; m is a total number of bits of the second digital signal, and n is a total number of bits of the fourth digital signal.

At operation 603, determining, by the output detection circuit, to stop the inter-stage gain calibration according to the digital output signal corresponding to the current gain control code and the digital output signal corresponding to the previous gain control code, determining a desired gain control code and outputting the desired gain control code to the gain configuration circuit, adjusting, by the gain configuration circuit, the inter-stage gain of the inter-stage amplifier according to the desired gain control code; the desired gain control code is one of the current gain control code or the previous gain control code.

In some implementations, the determining, by the output detection circuit, to stop the inter-stage gain calibration according to the digital output signal corresponding to the current gain control code and the digital output signal corresponding to the previous gain control code includes: comparing, by the output detection circuit, the digital output signal corresponding to the current gain control code with the digital output signal corresponding to the previous gain control code; and determining, by the output detection circuit, that a jump between the digital output signal corresponding to the current gain control code and the digital output signal corresponding to the previous gain control code is from a fifth digital signal to a sixth digital signal; an $(m+n-1)^{th}$ bit and an $(n-1)^{th}$ bit in the fifth digital signal are 1, and the rest bits are 0; an $(m+n-1)^{th}$ bit, and an $(n-2)^{th}$ bit to a first bit in the sixth digital signal are 1, and the rest bits are 0; m is a total number of bits of the second digital signal, and n is a total number of bits of the fourth digital signal.

In some implementations, the determining, by the output detection circuit, a desired gain control code and outputting the desired gain control code to the gain configuration circuit refers to that the output detection circuit outputs the desired gain control code to the gain configuration circuit, and subsequently does not adjust the gain control code output to the gain configuration circuit according to the digital output signal.

In some implementations, the analog input signal includes $V_{CM}+V_{small}/2$ and $V_{CM}-V_{small}/2$; $V_{CM}$ is an input common-mode voltage of the analog-to-digital converter, and $V_{small}$ is a micro-positive voltage quantity; in a case of $0<V_{small}<<V_{ref1}/2^m$, the desired gain control code is the previous gain control code; in a case of $-V_{ref1}/2^m<<V_{small}<0$, the desired gain control code is the current gain control code; $V_{ref1}/2^m$ is a voltage corresponding to a least significant bit (LSB) of the first-stage analog-to-digital sub-converter.

A reason why the desired gain control code is located at the jump between the fifth digital signal and the sixth digital signal is explained below.

Assuming that a reference voltage of the first-stage analog-to-digital sub-converter is $V_{ref1}$, a reference voltage of the second-stage analog-to-digital sub-converter is $V_{ref2}$, then a voltage corresponding to the LSB of the first-stage analog-to-digital sub-converter is $V_{ref1}/2^m$, a voltage corresponding to a LSB of the second-stage analog-to-digital sub-converter is $V_{ref2}/2^n$.

Assuming that an input common-mode voltage of the analog-to-digital converter is $V_{CM}$, an output common-mode voltage of the first-stage analog-to-digital sub-converter is $V_{CM1O}$, and an output common-mode voltage of the second-stage analog-to-digital sub-converter is $V_{CM2I}$, if the analog input signal includes differential signals $V_{inp1}$ and $V_{inn1}$, i.e., specific values $V_{CM}+V_{small}/2$ and $V_{CM}-V_{small}/2$ respectively; $V_{CM}$ is the input common-mode voltage of the analog-to-digital converter, $W_{small}$ is a micro-positive voltage quantity, the second voltage signal includes $V_{resp}$ and $V_{resn}$, as shown in equation (1) and equation (2).

$$V_{resp}=V_{CM1O}+V_{small}/2-V_{ref1}/2^{m+1} \qquad (1)$$

$$V_{resn}=V_{CM1O}-V_{small}/2+V_{ref1}/2^{m+1} \qquad (2)$$

The corresponding residual voltage is shown in equation (3).

$$V_{resp}-V_{resn}=V_{small}-V_{ref1}/2^m \qquad (3)$$

If the gain control code corresponds to the desired value $G_0$ of the inter-stage gain, then the third voltage signal is as shown in equations (4) and (5).

$$V_{inp2}=V_{CM2I}+G_0(V_{small}/2-V_{ref1}/2^{m+1}) \qquad (4)$$

$$V_{inn2}=V_{CM2I}-G_0(V_{small}/2-V_{ref1}/2^{m+1}) \qquad (5)$$

If the first digital signal output by the first-stage analog-to-digital sub-converter is processed by the first processing circuit and then the second digital signal output is $D_{stg1}=(100...00)_2$ ((m-1) zeros in total), and the third digital signal output by the second-stage analog-to-digital sub-converter is processed by the second processing circuit and then the fourth digital signal output is $D_{stg2}=(01...00)_2$ (an $(n-1)^{th}$ bit is 1, and the rest bits are 0), then the digital output signal of the analog-to-digital converter is $D_{out}=(010...010...0)_2$, (an $(m+n-1)^{th}$ bit and an $(n-1)^{th}$ bit are 1, and the rest bits are 0), which is a correct output value.

If a bias occurs in the inter-stage gain, the digital output signal of the analog-to-digital converter may be erroneous. Assuming in a non-ideal case, an expression of the inter-stage gain G is as equation (6), a is a variation range of an error of the gain.

$$G=G_0(1+a)=2^{m-1}(V_{ref2}/V_{ref1})(1+a) \qquad (6)$$

The corresponding third voltage signal is as shown in equation (7) and equation (8).

$$V_{inp2}=V_{CM21}+G_0(1+a)(V_{small}/2-V_{ref1}/2^{m+1}) \qquad (7)$$

$$V_{inn2}=V_{CM21}-G_0(1+a)(V_{small}/2-V_{ref1}/2^{m+1}) \qquad (8)$$

Analyzing a conversion process of the second-stage analog-to-digital sub-converter, if $-1/2^{n-2}<a<0$, the digital output signal of the analog-to-digital converter is $D_{out}=(010...010...0)_2$ (an $(m+n-1)^{th}$ bit and an $(n-1)^{th}$ bit are 1, and the rest bits are 0); if $0<a<1/2^{n-2}$, the digital output signal of the analog-to-digital converter is $D_{out}=(010...111...1)_2$ (an $(m+n-1)^{th}$ bit, and an $(n-2)^{th}$ bit to a first bit are 1, and the rest bits are 0).

Taking a specific number as an example, assuming that m=n=4, if $-1/4<a<0$, the digital output signal of the analog-to-digital converter is $D_{out}=(01000100)_2$, if $0<a<1/4$, the digital output signal of the analog-to-digital converter is $D_{out}=(01000011)_2$. That is, if a=0, i.e., the desired value of the inter-stage gain occurs, it is located at a jump of digital output signals corresponding to two adjacent gain control codes described above. According to this phenomenon, if a=0, an actual value G of the inter-stage gain is closest to the desired value $G_0$, assuming that values of the two gain control codes are respectively an integer k and an integer k+1, and for a value range of $0<V_{small}<<V_{ref1}/2^m$ and the value of the gain control code is k, the corresponding digital output signal is the correct output value $D_{out}=(010...010...0)_2$, (an $(m+n-1)^{th}$ bit and an $(n-1)^{th}$ bit are 1, and the rest bits are 0), so that the desired gain control code is selected to be k, for a value range of $-V_{ref1}/2^m<<V_{small}<0$ and the value of the gain control code is k+1, the corresponding digital output signal is the correct output value $D_{out}=(010...010...0)_2$, (an $(m+n-1)^{th}$ bit and an $(n-1)^{th}$ bit are 1, and the rest bits are 0), so that the desired gain control code is selected to be k+1.

According to the inter-stage gain calibration method provided in the embodiment of the present application, the desired value of the inter-stage gain can be obtained according to the digital output signal corresponding to the current gain control code and the digital output signal corresponding to the previous gain control code, the method is simple and has a relatively low complexity.

It should be understood by those of ordinary skill in the art that all or some of the operations in the method, the functional modules/components in the system and apparatus applied above may be implemented as software, firmware, hardware, or suitable combinations thereof. In a hardware implementation, the division between the functional modules/components stated above does not correspond to the division of physical components; for example, one physical component may have a plurality of functions, or one function or operation may be performed through a cooperation of several physical components. Some or all of the physical components may be implemented as software executed by a processor, such as a central processing unit, a digital signal processor or a microprocessor, or may be implemented as hardware, or may be implemented as an integrated circuit, such as an application specific integrated circuit. Such software may be allocated on a computer-readable medium, the computer-readable medium may include computer storage medium (or non-transitory medium) and communication medium (or transitory medium). The computer storage medium includes volatile/nonvolatile or removable/non-removable medium used in any method or technology for storing information (such as computer-readable instructions, data structures, program modules and other data). The computer storage medium includes, but is not limited to, a Random Access Memory (RAM), a Read-Only Memory (ROM), an Electrically Erasable Programmable Read-Only Memory (EEPROM), a flash memory or other memory techniques, a Compact Disc Read-Only Memory (CD-ROM), a Digital Video Disk (DVD) or other optical discs, magnetic cassettes, magnetic tapes, magnetic disks or other magnetic storage devices, or any other medium which can be used to store the desired information and can be accessed by a computer. The communication medium generally includes computer-readable instructions, data structures, program modules or other data in a modulated data signal, such as a carrier wave or other transmission mechanism, and may include any information delivery medium.

The present application applies the exemplary embodiments, and although specific terms are employed, they are used and should only be interpreted in a generic and descriptive meaning but not for purposes of a limitation. It is apparent to those skilled in the art that features, characteristics and/or elements described in connection with specific embodiments may be used alone or in combination with features, characteristics and/or elements described in connection with other embodiments, unless explicitly stated otherwise. Therefore, it should be understood by those skilled in the art that various changes in form and details may be made without departing from the scope of the present application as set forth in the appended claims.

**Claims**

1. An analog-to-digital converter, comprising:

   a sample-and-hold circuit configured to periodically sample and hold an analog input signal;
   a first-stage analog-to-digital sub-converter configured to perform a first analog-to-digital conversion on a held analog input signal to obtain a first digital signal, perform a digital-to-analog conversion on the first digital signal to obtain a first voltage signal, and comparing the held analog input signal and the first voltage signal to obtain a second voltage signal;
   a first processing circuit configured to perform a clock synchronization and a cycle delay on the first digital signal to obtain a second digital signal;
   an inter-stage amplifier implemented in an open-loop structure and configured to perform amplification processing on the second voltage signal to obtain a third voltage signal;
   a second-stage analog-to-digital sub-converter configured to perform a second analog-to-digital conversion on the third voltage signal to obtain a third digital signal;
   a second processing circuit configured to perform a clock synchronization on the third digital signal to obtain a fourth digital signal; and
   an adder configured to combine and add the second digital signal serving as a high-order codeword and the fourth digital signal serving as a low-order codeword to obtain a digital output signal.

2. The analog-to-digital converter of claim 1, further comprising:

   an output detection circuit configured to output a gain control code to a gain configuration circuit according to the digital output signal; and
   the gain configuration circuit configured to adjust an inter-stage gain of the inter-stage amplifier according to the gain control code.

3. The analog-to-digital converter of claim 1 or 2, wherein the analog input signal, the first voltage signal, the second voltage signal and the third voltage signal are differential signals.

4. The analog-to-digital converter of claim 1 or 2, wherein the inter-stage amplifier comprises a transconductance component and a resistor string;
   an input end of the transconductance component is connected to an output end of the first-stage analog-digital sub-converter, the output end of the first-stage analog-digital sub-converter is configured to output the second voltage signal, an output end of the transconductance component is connected to an input end of the second-stage analog-digital sub-converter and is connected to ground or a power supply or a common-mode direct current level through the resistor string.

5. The analog-to-digital converter of claim 1 or 2, wherein the adder is further configured to:
   supplement (n-1) zeros in a latter part of the second digital signal, add the second digital signal supplemented with zeros and the fourth digital signal to obtain the digital output signal; wherein n is a total number of bits of the fourth digital signal.

6. An inter-stage gain calibration method, applied to a front-end calibration phase of the analog-to-digital converter of any one of claims 2 to 5, comprising:

   adjusting, by a gain configuration circuit, an inter-stage gain of an inter-stage amplifier according to a current gain control code; wherein the current gain control code is an integer between 0 to $2^q-1$, q is an integer greater than or equal to 2;

determining, by an output detection circuit, to continue inter-stage gain calibration according to a digital output signal corresponding to the current gain control code and a digital output signal corresponding to a previous gain control code, adding 1 to the current gain control code to obtain a next gain control code, and adjusting, by the gain configuration circuit, the inter-stage gain of the inter-stage amplifier according to the next gain control code; and

determining, by the output detection circuit, to stop the inter-stage gain calibration according to the digital output signal corresponding to the current gain control code and the digital output signal corresponding to the previous gain control code, determining a desired gain control code and outputting the desired gain control code to the gain configuration circuit, adjusting, by the gain configuration circuit, the inter-stage gain of the inter-stage amplifier according to the desired gain control code; wherein the desired gain control code is one of the current gain control code or the previous gain control code.

7. The inter-stage gain calibration method of claim 6, wherein the determining, by an output detection circuit, to continue inter-stage gain calibration according to a digital output signal corresponding to the current gain control code and a digital output signal corresponding to a previous gain control code comprises:

comparing, by the output detection circuit, the digital output signal corresponding to the current gain control code with the digital output signal corresponding to the previous gain control code; and

determining, by the output detection circuit, that no jump is occurred between the digital output signal corresponding to the current gain control code and the digital output signal corresponding to the previous gain control code; or, a jump between the digital output signal corresponding to the current gain control code and the digital output signal corresponding to the previous gain control code is not from a fifth digital signal to a sixth digital signal; wherein, an $(m+n-1)^{th}$ bit and an $(n-1)^{th}$ bit in the fifth digital signal are 1, and rest bits in the fifth digital signal are 0; an $(m+n-1)^{th}$ bit, and an $(n-2)^{th}$ bit to a first bit in the sixth digital signal are 1, and rest bits in the sixth digital signal are 0; wherein m is a total number of bits of the second digital signal, and n is a total number of bits of the fourth digital signal.

8. The inter-stage gain calibration method of claim 6, wherein the determining, by the output detection circuit, to stop the inter-stage gain calibration according to the digital output signal corresponding to the current gain control code and the digital output signal corresponding to the previous gain control code comprises:

comparing, by the output detection circuit, the digital output signal corresponding to the current gain control code with the digital output signal corresponding to the previous gain control code; and

determining, by the output detection circuit, that a jump between the digital output signal corresponding to the current gain control code and the digital output signal corresponding to the previous gain control code is from a fifth digital signal to a sixth digital signal; wherein, an $(m+n-1)^{th}$ bit and an $(n-1)^{th}$ bit in the fifth digital signal are 1, and rest bits in the fifth digital signal are 0; an $(m+n-1)^{th}$ bit, and an $(n-2)^{th}$ bit to a first bit in the sixth digital signal are 1, and rest bits in the sixth digital signal are 0; wherein m is a total number of bits of the second digital signal, and n is a total number of bits of the fourth digital signal.

9. The inter-stage gain calibration method of any one of claims 6 to 8, wherein the analog input signal includes $V_{CM}+V_{small}/2$ and $V_{CM}-V_{small}/2$; wherein $V_{CM}$ is an input common-mode voltage of the analog-to-digital converter, and $V_{small}$ is a micro-positive voltage quantity;

in reponse to $0<V_{small}<<V_{ref1}/2^m$, the desired gain control code is the previous gain control code;
wherein $V_{ref1}/2^m$ is a voltage corresponding to a least significant bit of the first-stage analog-to-digital sub-converter.

10. The inter-stage gain calibration method of any one of claims 6 to 8,
wherein the analog input signal includes $V_{CM}+V_{small}/2$ and $V_{CM}-V_{small}/2$; wherein $V_{CM}$ is an input common-mode voltage of the analog-to-digital converter, and $V_{small}$ is a micro-positive voltage quantity;

in response to $-V_{ref1}/2^m<<V_{small}<0$, the desired gain control code is the current gain control code;
wherein $V_{ref1}/2^m$ is a voltage corresponding to a least significant bit of the first-stage analog-to-digital sub-converter.

FIG. 1

109

Gain
Configuration
Circuit

GAIN<q:1>

101

Sample
and Hold
Circuit

$V_{inp1}$

$V_{inn1}$

102

First-Stage
Analog-to-
Digital Sub-
Converter

$V_{resp}$

$V_{resn}$

104
$V_{inp2}$

Inter-Stage
Amplifier

$V_{inn2}$

105

Second-
Stage
Analog-to-
Digital Sub-
Converter

103

First
Processing
Circuit

$D_{o1}<m:1>$

107

Adder

$D_{o2}<n:1>$

106

Second
Processing
Circuit

$D_{out}<m+n:1>$

108

Output
Detection
Circuit

FIG. 2

11

FIG. 3

FIG. 4

|  |  |  |  |  |  |  |  |  |
|---|---|---|---|---|---|---|---|---|
| $D_{o1}<m>$ | ······ | $D_{o1}<2>$ | $D_{o1}<1>$ | $0$ | ······ | $0$ |  | $0$ |
| $+$ |  |  |  | $D_{o2}<n>$ | $D_{o2}<n-1>$ | ······ | $D_{o2}<2>$ | $D_{o2}<1>$ |
| $D_{out}<m+n>$ $D_{out}<m+n-1>$ ······ $D_{out}<n+1>$ | $D_{out}<n>$ | $D_{out}<n-1>$ | ······ | $D_{out}<2>$ | $D_{out}<1>$ |  |  |  |

FIG. 5

| | |
|---|---|
| Adjust, by a gain configuration circuit, an inter-stage gain of an inter-stage amplifier according to a current gain control code; the current gain control code is an integer between 0 to $2^{q}-1$, q is an integer greater than or equal to 2 | 601 |
| Determine, by an output detection circuit, to continue inter-stage gain calibration according to a digital output signal corresponding to the current gain control code and a digital output signal corresponding to a previous gain control code, adding 1 to the current gain control code to obtain a next gain control code, and adjusting, by the gain configuration circuit, the inter-stage gain of the inter-stage amplifier according to the next gain control code | 602 |
| Determine, by the output detection circuit, to stop the inter-stage gain calibration according to the digital output signal corresponding to the current gain control code and the digital output signal corresponding to the previous gain control code, determining a desired gain control code and outputting the desired gain control code to the gain configuration circuit, adjust, by the gain configuration circuit, the inter-stage gain of the inter-stage amplifier according to the desired gain control code; the desired gain control code is one of the current gain control code or the previous gain control code | 603 |

FIG. 6

## INTERNATIONAL SEARCH REPORT

| International application No. |
|---|
| **PCT/CN2022/081949** |

**A.      CLASSIFICATION OF SUBJECT MATTER**

H03M 1/10(2006.01)i

According to International Patent Classification (IPC) or to both national classification and IPC

**B.      FIELDS SEARCHED**

Minimum documentation searched (classification system followed by classification symbols)

H03M1/-

Documentation searched other than minimum documentation to the extent that such documents are included in the fields searched

Electronic data base consulted during the international search (name of data base and, where practicable, search terms used)

CNABS; CNTXT; VEN; WPABS; ENTXT; USTXT; WOTXT; CNKI: 模数转换, AD转换, 级间, 放大器, 开环, 闭环, 负反馈, 闭合反馈, 级间增益, 增益, 校准, 校正, 调整, 跨导, 电阻, 控制码, analog-digital conversion, AD conversion, interstage, amplifier, open-loop, closed-loop, negative feedback, closed feedback, stagegain, gain, correct, calibrate, rectify, adjust, transconductance, resistance, control code

**C.      DOCUMENTS CONSIDERED TO BE RELEVANT**

| Category* | Citation of document, with indication, where appropriate, of the relevant passages | Relevant to claim No. |
|---|---|---|
| X | CN 110299916 A (ANALOG DEVICES, INC.) 01 October 2019 (2019-10-01) description, paragraphs 0035-0545, and figures 1-56 | 1-5 |
| X | CN 112019217 A (ZHEJIANG UNIVERSITY) 01 December 2020 (2020-12-01) description, paragraphs 0035-0080 | 1-5 |
| X | US 2007176814 A1 (CLARIPHY COMMUNICATIONS INC.) 02 August 2007 (2007-08-02) description, paragraphs 0028-0053 | 1-3, 5 |
| A | CN 111585574 A (CHENGDU SINO MICROELECTRONICS TECHNOLOGY CO., LTD.) 25 August 2020 (2020-08-25) entire document | 1-10 |
| A | CN 113114247 A (UNIVERSITY OF ELECTRONIC SCIENCE AND TECHNOLOGY OF CHINA) 13 July 2021 (2021-07-13) entire document | 1-10 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 June 2022** | **29 June 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/081949**

| Patent document cited in search report | | | Publication date (day/month/year) | Patent family member(s) | | | Publication date (day/month/year) |
|---|---|---|---|---|---|---|---|
| CN | 110299916 | A | 01 October 2019 | US | 2019296756 | A1 | 26 September 2019 |
| | | | | DE | 102019107170 | A1 | 26 September 2019 |
| CN | 112019217 | A | 01 December 2020 | CN | 112019217 | B | 12 February 2021 |
| US | 2007176814 | A1 | 02 August 2007 | US | 7576676 | B2 | 18 August 2009 |
| CN | 111585574 | A | 25 August 2020 | None | | | |
| CN | 113114247 | A | 13 July 2021 | None | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111189751